# EUROPEAN PATENT APPLICATION

(11) **EP 2 690 936 A1**
(43) Date of publication of application: **29.01.2014**
(21) Application number: 12866411.7
(22) Date of filing: 30.05.2012
(51) Int. Cl.: H05K 1/18

(54) **ELECTRONIC DEVICE**

(71) Applicant: Sanyo Electric Co., Ltd., Osaka 570-8677 (JP)
(72) Inventor: SAITO, Takao, Moka City Tochigi 3214397 (JP); OSHIMA, Makoto, Moka City Tochigi 3214397 (JP); OHASHI, Masaaki, Moriguchi-shi Osaka 5708677 (JP)
(74) Representative: Glawe, Delfs, Moll
(86) International application number: PCT/JP2012/063838
(87) International publication number: WO 2013/179404

(57) **Abstract**

The electronic device of the present invention is an electronic device configured by soldering a terminal member to a printed circuit board, the terminal member comprising a top surface into which a screw is threaded and a side surface at the end connected to the top surface, the side surface having convex parts fitted into through-holes in the printed circuit board; wherein the terminal member has at least two convex parts in the end edge on the printed circuit board side of the side surface, an electro conductive pattern is provided on the printed circuit board facing the end edge between the convex parts, solder is filled into a gap between the end edge and the electro conductive pattern, when the two convex parts are inserted into the through-holes provided to the electro conductive pattern, and electrical continuity is established between the end edge and the electro conductive pattern.

## Description

### TECHNICAL FIELD

The present invention relates to a configuration used when a terminal is directly soldered onto a printed circuit board of an electronic device.

### BACKGROUND ART

Terminals, connectors, and the like are usually used to receive signals, electric power, and the like from one printed circuit board to another printed circuit board or an electronic component or the like, and devices have been devised in which the size of the device is reduced and a terminal for channeling a comparatively large electric current is supplied directly to a printed circuit board.

In this case, a power wire must be screwed to this terminal with a suitable amount of torque because of the channeling a large electric current, and the terminal must be attached on the circuit board with a strength capable of withstanding this torque. Because of the channeling of a large electric current, the resistance value between the terminal and the electro conductive pattern on the printed circuit board must also be reduced to suppress the heat generating.

Attaching a terminal such as the one cited in Patent Reference 1 has been devised as a measure of improvement. This attachment involves attaching jumper wires to the sides of the leg portion of the terminal which is soldered to the printed circuit board, and preventing separation of the terminal resulting from peeling of the electro conductive pattern.

The prior art discloses a device in which a flange is provided to the electro conductive pattern side of the terminal, and the flange is used to solder the terminal to a surface.

### [Prior Art References]

### [Patent References]

[Patent Reference 1]: Japanese Laid-open Patent Application No. 2009-38163

### DISCLOSURE OF THE INVENTION

### [Problems the Invention Is Intended To Solve]

In the conventional art, attaching the terminal to the electro conductive pattern is within the normal soldering, and the vertical attachment force is strengthened but is yet insufficient relative to the rotational torque when screwing the power wire in order to channel a large electric current.

The category of this soldering is normal, and the surface area of conduction between the terminal and the electro conductive pattern has been insufficient for channeling a large electric current.
In the case of soldering using the flange provided to the terminal, there are cases in which the solder does not sufficiently circulate between the surface of the flange and the electro conductive pattern, and it is difficult to ensure sufficient strength and a substantial surface area of conduction.

### [Means for Solving the Abovementioned Problems]

The electronic device of the present invention is an electronic device configured by soldering a terminal member to a printed circuit board, the terminal member having a top surface into which a screw is threaded and having a side surface at the end connected to the top surface, the side surface having convex parts inserted into through-holes in the printed circuit board; the electronic device characterized in that the terminal member has at least two convex parts in the end edge on the printed circuit board side of the side surface, an electro conductive pattern is provided on the printed circuit board facing the end edge between the convex parts, solder is filled into a gap between the end edge and the electro conductive pattern, when the two convex parts are inserted into the through-holes provided to the electro conductive pattern, and electrical continuity is established between the end edge and the electro conductive pattern.

By configuring the present invention in this manner, the side surface end edge of the terminal member and the electro conductive pattern can be bonded together by solder.

The electronic device is also characterized in that the gap is provided to the convex parts and is configured to regulate the amount by which the convex parts are inserted into the through-holes.

The electronic device is also characterized in that the gap is configured from a recess formed in the end edge, and electrical continuity is established between the inner edge of the recess and the electro conductive pattern.

The electronic device is also characterized in that jumper wires are provided on the electro conductive pattern in alignment with the side surface of the terminal member, and solder is filled in between the jumper wires and the side surface.

The electronic device is also characterized in that two side surfaces are provided to the top surface, and the two surfaces have the same configuration.

The electronic device is also characterized in that the through-holes are shaped as long circles, and concave parts are provided extending outward in the longitudinal edges of these circles.

The printed circuit board of the present invention is an electronic device configured by soldering a terminal member to a printed circuit board, the terminal member comprising a top surface into which a screw is threaded and a side surface at the end connected to the top surface, the side surface having convex parts inserted into through-holes in the printed circuit board; the electronic device characterized in that the terminal member has at least two convex parts in the end edge on the printed circuit board side of the side surface, the end edge has a recess between the convex parts, an electro conductive pattern is provided on the printed circuit board facing the recess, and after the two convex parts have been inserted into the through-holes provided to the electro conductive pattern, solder is filled so as to connect the electro conductive pattern and the inner edge of the recess.

### [Effect of the Invention]

In the electronic device of the present invention, soldering is used to reinforce the gap connection between the electro conductive pattern and the space between the convex parts of the side surface of the terminal member. At the same time, the solder between the side surface of the terminal member and the electro conductive pattern can be used in the surface area of conduction for channeling an electric current, and the heat, when a large electric current is channeled, can be suppressed.

### BRIEF DESCRIPTION OF THE DRAWINGS

FIG. 1 is an explanatory drawing showing an embodiment of the present invention;
FIG. 2 is an explanatory drawing showing a state in which the terminal member shown in FIG. 1 has been soldered to the printed circuit board;
FIG. 3 is an explanatory drawing showing a cross section of the state shown in FIG. 2;
FIG. 4 is an explanatory drawing showing another embodiment of the terminal member;
FIG. 5 is an explanatory drawing showing another embodiment of the terminal member;
FIG. 6 is an explanatory drawing showing another embodiment of the terminal member;
FIG. 7 is an explanatory drawing showing another shape of the through-holes configured in the electro conductive pattern; and
FIG. 8 is an explanatory drawing showing the relationship between the side surface of the terminal member and the jumper wires.

### BEST MODE FOR CARRYING OUT THE INVENTION

When a terminal member is attached to a printed circuit board, increasing the attachment strength of the terminal member to the printed circuit board and reducing conduction resistance are achieved using a solder.

### [Embodiment 1]

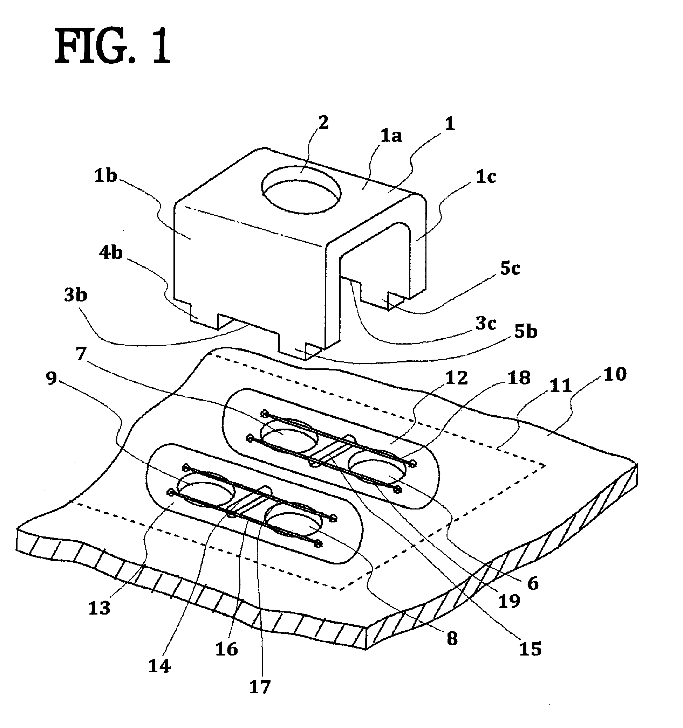

FIG. 1 is an explanatory drawing of a terminal member used in an embodiment of the present invention. The terminal member 1 in this drawing is configured from a top surface 1a having a screw hole 2 provided in the middle where grooves are cut for threading in a screw, and side surfaces 1b, 1c constituting the sides of the terminal member. This configuration is made by folding an aluminum sheet into a three-sided square shape, but the configuration is not limited as such, nor is it limited to cutouts of aluminum or the like. The material of the terminal member is not limited to aluminum, and may also be copper or another electro conductive material. Furthermore, there may be a plurality of screw holes formed in the top surface. A U-shaped terminal or a circular terminal, to which a leader wire is swaged or soldered, is screwed into the screw hole via a washer or a spring. A rotational torque (fastening torque) corresponding to the electric current value flowing to the leader wire is preferably used for this screwing, and the greater the electric current, the greater the rotational torque.

Convex parts 4b, 5b, 4c, 4b, which have shapes that are inserted or fitted into through-holes 6-9 provided to the printed circuit board, are provided in the end edges 3b, 3c of the side surfaces 1b, 1c. At least two of these convex parts are preferably provided in each of at least two of the side surfaces; for example, two convex parts are provided in accordance with both ends of the end edges when there is one screw hole in the top surface, and three screw holes are provided evenly when there are two screw holes in the top surface, but the number of screw holes and the number of convex parts are not limited to these examples; the numbers being adjustable as appropriate.

In the embodiment shown in FIG. 1, the convex part 4b is inserted into a through-hole 9, the convex part 5b is inserted into a through-hole 8, the convex part 4c is inserted into a through-hole 7, and the convex part 5c is inserted into a through-hole 6.

The through-holes 6-9 are provided to a printed circuit board 10, and are covered with an electro conductive metal film of copper or the like in order to provide a function of electrically connecting the electro conductive patterns on the front and rear sides and to improve solder wettability on the inner wall of the through-hole. The symbol 11 indicates the electro conductive pattern on the front side of the printed circuit board 10, the electro conductive patterns of the portions not covered by an insulating resist are specifically referred to as the electro conductive patterns 12, 13, and the electro conductive patterns 12, 13 are shown below.

The through-holes 6-9 have either a circular shape or a long circular shape (or ellipsoidal shape) extending along the side surfaces of the terminal member, and long-hole shaped (or ellipsoidal) through-holes 14, 15 are provided between the through-hole 6 and the through-hole 7 and between the through-hole 8 and the through-hole 9, the long edges thereof being longer than the diameters of the through-holes. These lengths are preferably greater than the thickness of the side surfaces when the convex parts of the side surfaces of the terminal member 1 are inserted into the respective through-holes, or the lengths are preferably of a size whereby gaps can be formed with the side surfaces such that molten solder can pass through the gaps from the rear side of the printed circuit board 10.

The numbers 16-19 indicate jumper wires, and the jumper wires 16, 17 are placed so as to span the through-holes 9, 14, 8, while the jumper wires 18, 19 are placed so as to span the through-holes 7, 15, 6.

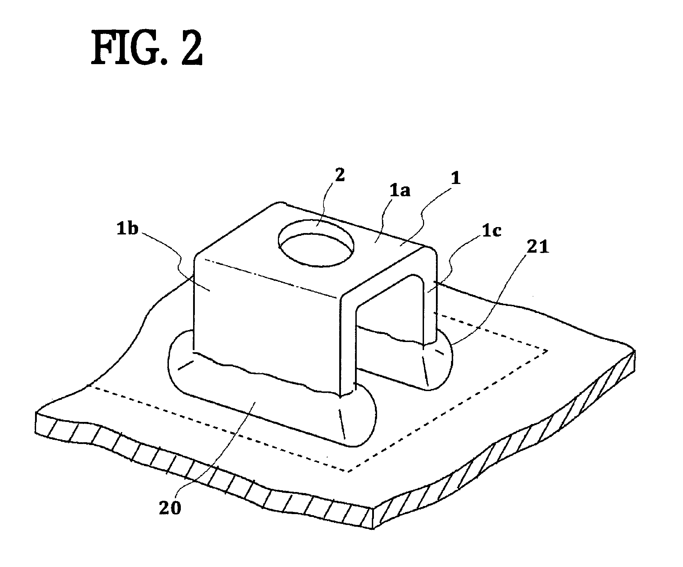

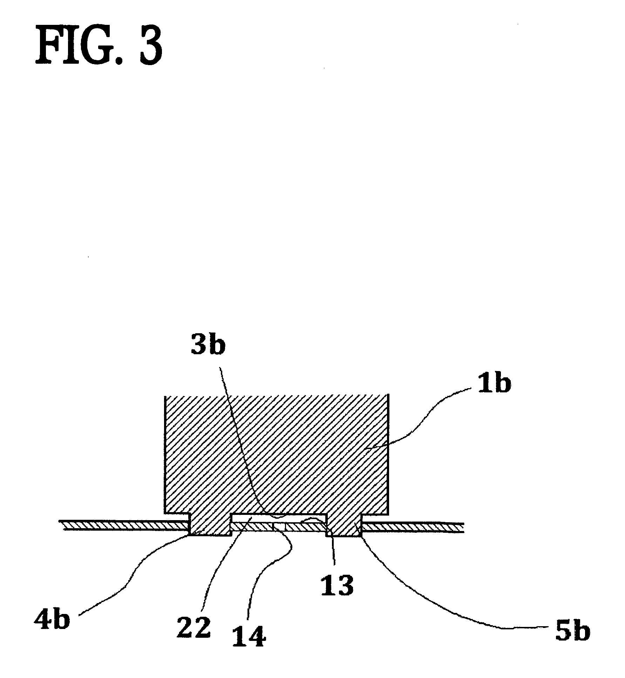

FIG. 2 is a drawing of a state in which the convex parts 5c, 4c, 5b, 4b have been inserted into the respective through-holes 6-9 of the printed circuit board 10 and then soaked in a solder melted pool and soldered. The symbols 20 and 21 indicate solder swollen on the side surfaces 1c, 1b of the terminal member 1 and on top of the electro conductive pattern. FIG. 3 is an explanatory drawing showing a cross section of this state, wherein the convex parts 4b, 5b are inserted into the through-holes 9, 8, and this insertion forms a gap 22 where the end edge 3b of the side surface 1b of the terminal member 1 does not make contact with the electro conductive pattern 13. Even if the terminal member 1 is firmly pushed in, the gap 22 is narrowed but adhesion with the electro conductive pattern 13 is insufficient, and while there is contact resistance between the end edge 3b and the electro conductive pattern 13, the through-hole 14 is provided in the electro conductive pattern 13 so as to face the end edge 3b, and due to the printed circuit board being placed in a solder melting pool , molten solder rises through the through-hole 14 from the rear side of the printed circuit board and fills in the gap 3b.

Due to the solder filling in the gap 22 in this manner, the end edge 3b of the side surface 1b and the electro conductive pattern 13 are directly soldered together, and the attachment of the terminal member 1 to the printed circuit board 10 is strengthened in accordance with the soldering of the convex parts 4b, 5b to the electro conductive pattern 13. The solder in the gap 22 also acts as an electric current path between the terminal member 1 and the electro conductive pattern, the electro conductive surface area increases proportionately, and the heat generated during electric current charging can be suppressed.

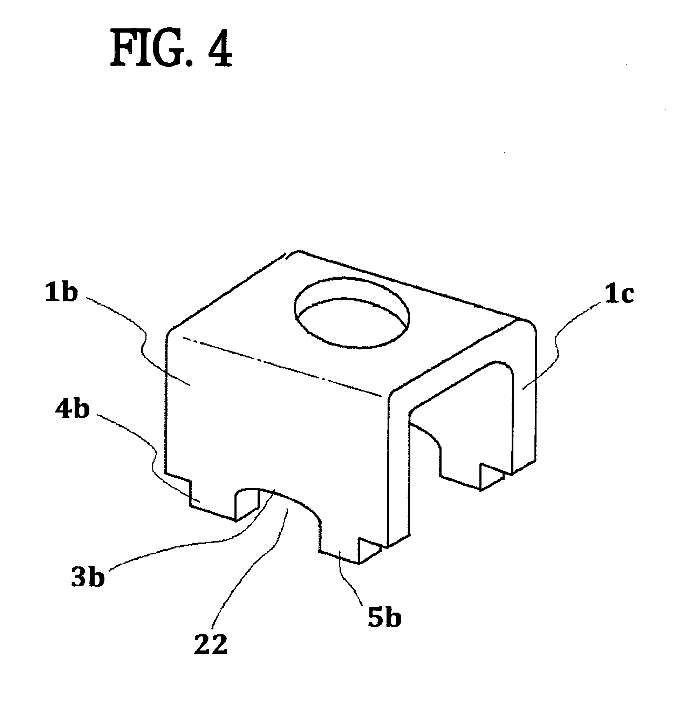

FIG. 4 is an explanatory drawing showing another embodiment of the terminal member 1, wherein the gap 22 (indicated by the same symbol as the terminal member shown in FIG. 1) is formed by a recessed part (or a cutout part or formed part) configured between the convex parts 4b, 5b provided to the end edge 3b of the side surface 1b.

The configuration is designed so that when the convex parts 4b, 5b of the side surface are inserted into the through-holes 9, 8 of the printed circuit board, the gap 22 or a space can be formed between the inner edge of the recessed part and the electro conductive pattern. When the terminal member 1 is attached to the printed circuit board 10, the gap 22 is filled with solder via the through-hole 14, similar to the embodiment shown in FIG. 3, and the side surface 1b and the electro conductive pattern 13 are soldered together. The side surface 1c has a similar configuration.

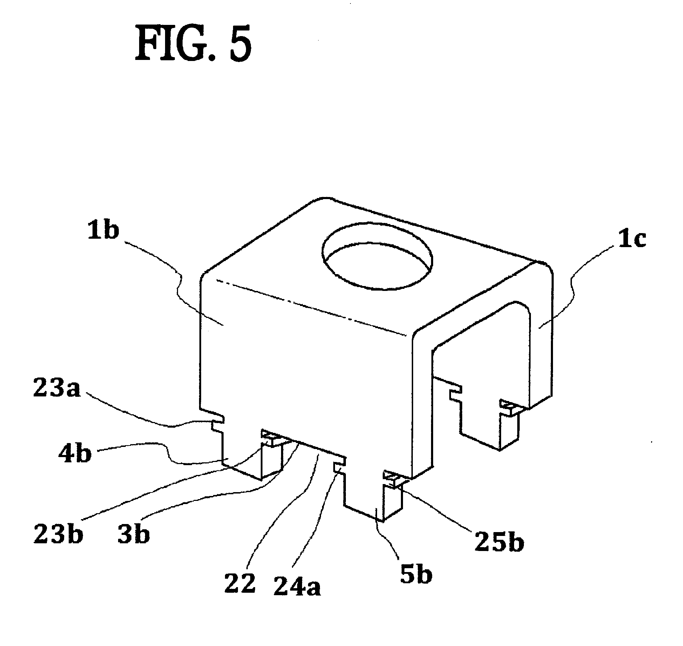

FIG. 5 is a drawing showing another embodiment of the terminal member, wherein the shapes of the convex parts 4b, 5b are different from those of the terminal member 1 shown in FIG. 4, there is no recess in the end edge 3b of the side surface 1b, there are two levels of thickness in the convex part 4b, the thickly configured portions 23a, 23b near the end edge 3b are thicker than the inside diameters of the through-holes 9, 8, and only the thin portions at the tips are inserted into the through-holes. When the terminal member is mounted on the printed circuit board, a gap 22 is formed between the end edge 3b of the side surface 1b and the surface of the electro conductive pattern 13 of the printed circuit board (or the electro conductive pattern), the gap being proportionate to these thick portions 23a, 23b of the convex part 4b. This gap 22 is filled with solder and the side surface 1b and the electro conductive pattern 13 are soldered together, similar to the terminal member shown in FIG. 4. The side surface 1c has a similar configuration.

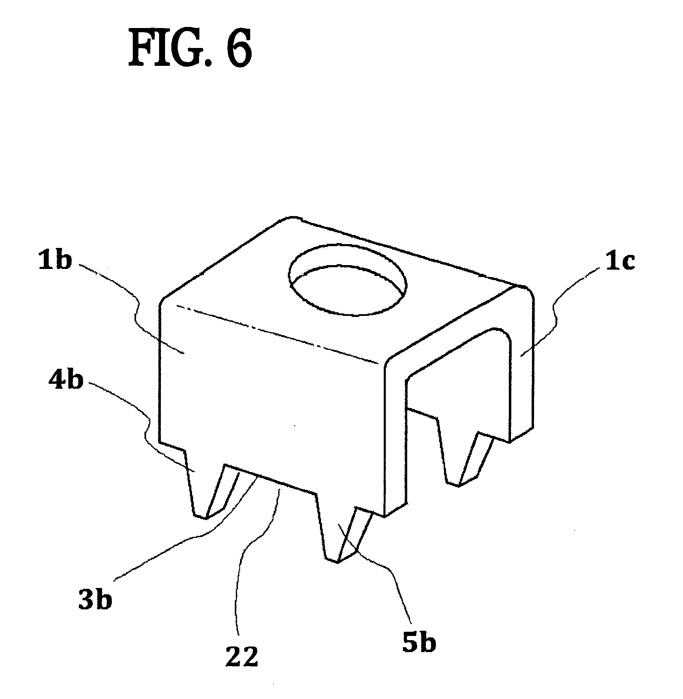

In the terminal member shown in FIG. 6, the convex parts are configured into tapering shapes in which the distal ends gradually become narrower, the convex parts 4b, 5b are inserted into the through-holes up to certain positions, and a gap 22 is formed between the end edge 3b of the side surface 1b and the printed circuit board 10 midway through. This gap 22 is filled with solder and the side surface 1b and the electro conductive pattern 13 are soldered together, similar to the terminal member shown in FIG. 4. The side surface 1c has a similar configuration.

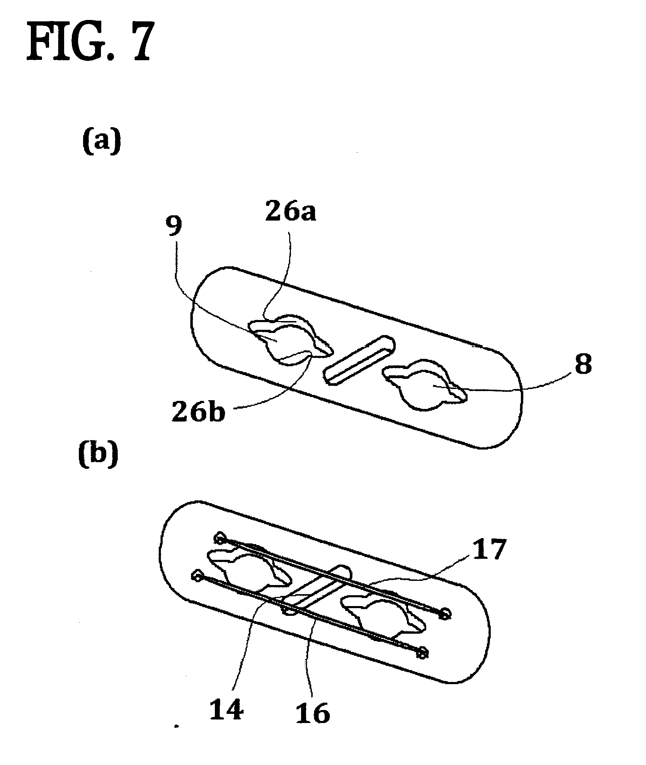

FIG. 7(a) is an explanatory drawing showing through-holes of another shape, wherein the through-holes 8, 9 having long circular shapes or ellipsoidal shapes also have concave parts 26a, 26b widening outward from the edges of the inner peripheries on the longitudinal sides, and spaces filled with solder are configured between these concave parts 26a, 26b and the convex part 4b inserted into the through-hole. The inner peripheral surface area of this through-hole is increased by these concave parts 26a, 26b, and by filling these spaces with solder, the inner peripheral surface area of the through-hole facing the convex part 4b of the terminal member can be increased, electro conductive resistance between these surfaces can be reduced, and the heat, when a large electric current is channeled, can be suppressed. The through-hole 8 has a similar configuration. FIG. 7(b) is an explanatory drawing of a state in which the jumper wires 16, 17 have also been attached, wherein the jumper wires 16, 17 are attached spanning across the concave parts 26a, 26b, the through-hole 14, and the concave parts of the through-hole 8 (not indicated by symbols).

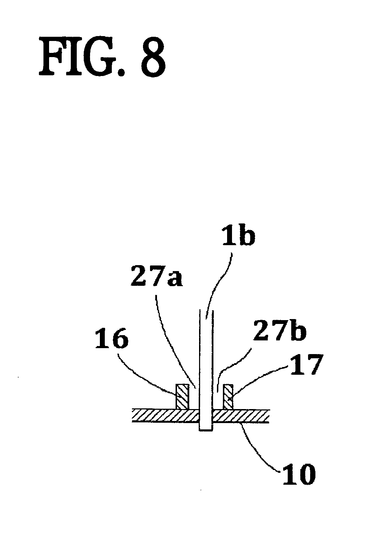

FIG. 8 is an explanatory drawing showing the relationship with the jumper wires 16, 17 in a state in which the concave parts of the terminal member have been inserted into the printed circuit board, wherein the jumper wires 16, 17 are provided parallel to the side surface 1b, leaving gaps 27a, 27b thereinbetween, and in these gaps, the molten solder rises due to capillarity. Therefore, due to placing the printed circuit board in a solder melting pool, the gaps 27a, 27b are filled with solder, the side surface 1b and the jumper wires 16, 17 are soldered together, the attachment strength of the side surface 1b to the printed circuit board is increased, the energized surface area is increased by the solder, and the heat generated when a large electric current is channeled can be suppressed.

### INDUSTRIAL APPLICABILITY

The present invention can be used in an electronic device in which a terminal member is directly attached to a printed circuit board, and can be provided not only in terminal members channeling a large electric current, but also in terminal members in which the object is to ensure attachment strength.

### [Key to Symbols]

1 Terminal member
1b Side surface
3b End edge
4b, 5b Convex parts
6-9, 14, 15 Through-holes
12, 13 Electro conductive patterns
16-19 Jumper wires
20, 21 Solder
22 Gap

## Claims

1. An electronic device configured by soldering a terminal member to a printed circuit board, the terminal member comprising a top surface into which a screw is threaded and a side surface at the end connected to the top surface, the side surface having convex parts inserted into through-holes in the printed circuit board; the electronic device **characterized in that** said terminal member has at least two convex parts in the end edge on said printed circuit board side of said side surface, an electro conductive pattern is provided on said printed circuit board facing said end edge between the convex parts, solder is filled into a gap between said end edge and said electro conductive pattern when said two convex parts are inserted into said through-holes provided to the electro conductive pattern, and electrical continuity is established between said end edge and said electro conductive pattern.

2. The electronic device according to claim 1, **characterized in that** said gap is provided to said convex parts and is configured to regulate the amount by which said convex parts are inserted into said through-holes.

3. The electronic device according to claim 1, **characterized in that** said gap is configured from a recess formed in said end edge, and electrical continuity is established between the inner edge of the recess and said electro conductive pattern.

4. The electronic device according to claim 2 or 3, **characterized in that** jumper wires are provided on said electro conductive pattern in alignment with the side surface of said terminal member, and solder is filled in between the jumper wires and said side surface.

5. The electronic device according to claim 4, **characterized in that** two of said side surfaces are provided to said top surface, and the two surfaces have the same configuration.

6. The electronic device according to claim 5, **characterized in that** said through-holes are shaped as long circles, and concave parts are provided extending outward in the longitudinal edges of these circles.

7. An electronic device configured by soldering a terminal member to a printed circuit board, the terminal member comprising a top surface into which a screw is threaded and a side surface at the end connected to the top surface, the side surface having convex parts inserted into through-holes in the printed circuit board; the electronic device **characterized in that** said terminal member has at least two convex parts in the end edge on said printed circuit board side of said side surface, said end edge has a recess between the convex parts, an electro conductive pattern is provided on said printed circuit board facing the recess, and after said two convex parts have been inserted into said through-holes provided to the electro conductive pattern, solder is filled so as to connect said electro conductive pattern and the inner edge of said recess.

## Amended claims

### Amended claims under Art. 19.1 PCT

**1.** An electronic device configured by soldering a terminal member to an printed circuit board , the terminal member having a top surface onto which a terminal of a leader wire is threaded by a screw and having a side surface at the end connected to the top surface, the side surface having convex parts inserted into through-holes in the printed circuit board; the electronic device **characterized in that** said terminal member has at least two convex parts in the end edge on said printed circuit board side of said side surface, an electro conductive pattern is provided on said printed circuit board facing said end edge between the convex parts, solder is filled into a gap between said end edge and said electro conductive pattern when said two convex parts are inserted into said through-holes provided to the electro conductive pattern in such a manner that the end edge and the electro conductive pattern are directly soldered together, and electrical continuity is established between said end edge and said electroconductive pattern.

**2.** The electronic device according to claim 1, **characterized in that** said gap is provided to said convex parts and is configured to regulate the amount by which said convex parts are inserted into said through-holes.

**3.** The electronic device according to claim 1, **characterized in that** said gap is configured from a recess formed in said end edge, and electrical continuity is established between the inner edge of the recess and said electroconductive pattern.

**4.** The electronic device according to claim 2 or 3, **characterized in that** jumper wires are provided on said electro conductive pattern in alignment with the side surface of said terminal member, and solder is filled in between the jumper wires and said side surface.

**5.** The electronic device according to claim 4, **characterized in that** two of said side surfaces are provided to said top surface, and the two surfaces have the same configuration.

**6.** The electronic device according to claim 5, **characterized in that** said through-holes are shaped as long circles, and concave parts are provided extending outward in the longitudinal edges of these circles.

**7.** An electronic device configured by soldering a terminal member to an printed circuit board , the terminal member comprising a top surface onto which a terminal of a leader wire is threaded by a screw and a side surface at the end connected to the top surface, the side surface having convex parts inserted into through-holes in the printed circuit board; the electronic device **characterized in that** said terminal member has at least two convex parts in the end edge on said printed circuit board side of said side surface, said end edge has a recess between the convex parts, an electroconductive pattern is provided on said printed circuit board facing the recess, and after said two convex parts have been inserted into said through-holes provided to the electroconductive pattern, solder is filled so as to connect said electroconductive pattern and the inner edge of said recess.
